# EUROPÄISCHE PATENTANMELDUNG

(11) **EP 1 845 611 A1**
(43) Veröffentlichungstag der Anmeldung: **17.10.2007**
(21) Anmeldenummer: 07006776.4
(22) Anmeldetag: 31.03.2007
(51) Int. Cl.: H03B 5/12, H03B 5/18

(54) **Integrierte differenzielle Oszillatorschaltung**

(30) Priorität: 12.04.2006 DE 102006017188
(71) Anmelder: ATMEL Duisburg GmbH, 47057 Duisburg (DE)
(72) Erfinder: El, Samir, 47057 Duisburg (DE); Tempel, Ralf, Dr., 47058 Duisburg (DE)
(74) Vertreter: Müller, Wolf-Christian

(57) **Zusammenfassung**

Vorgestellt wird eine Integrierte differenzielle Oszillatorschaltung (16), die eine Verstärkerschaltung (18) mit einem Eingang (20.1, 20.r) und einem Ausgang (22.1, 22.r), ein frequenzselektives Rückkopplungsnetzwerk (24) mit einer ersten Induktivität (26.1, 26.r) und einer zweiten Induktivität (28.1, 28.r) und eine Gleichstromversorgung (32) aufweist. Die Oszillatorschaltung zeichnet sich dadurch aus, dass der Ausgang (22.1, 22.r) über die erste Induktivität (26.1, 26.r) und die zweite Induktivität (28.1, 28.r) des Rückkopplungsnetzwerks (24) transformatorisch mit dem Eingang (20.1, 20.r) gekoppelt ist, wobei der Ausgang (22.1, 22.r) über die erste Induktivität (26.1. 26.r) und einen ersten Gleichstrompfad (36) an ein erstes DC-Potenzial (V1), und der Eingang (20.1, 20.r) über die zweite Induktivität (28.1, 28.r) und einen zweiten Gleichstrompfad (38) an ein zweites DC-Potenzial (V2) der Gleichstromversorgung (32) angeschlossen ist.

## Beschreibung

Die Erfindung betrifft eine Integrierte differenzielle Oszillatorschaltung, die eine Verstärkerschaltung mit einem Eingang und einem Ausgang, ein frequenzselektives Rückkopplungsnetzwerk mit einer ersten Induktivität und eine Gleichstromversorgung aufweist.

Eine solche Oszillatorschaltung ist aus der WO 99/43079 bekannt. Diese Schrift zeigt ein differenzielles Oszillatordesign mit zwei Schwingkreisen, die über eine Verstärkerschaltung aus zwei Transistoren in Basisschaltung entdämpft werden. In der Terminologie der WO 99/43079 besteht der erste Schwingkreis aus einem ersten Resonanzelement, einem ersten Rückführpfad und einem differenziellen Kopplungselement. Es werden verschiedene Ausgestaltungen angegeben, die sich durch verschiedene Kombinationen resistiver, kapazitiver, magnetischer und induktiver Ausgestaltungen der Bauelemente ergeben.

In einer Ausgestaltung, die eine induktive Rückkopplung zeigen soll, besitzt das erste Resonanzelement resistiven Charakter, der Rückführpfad induktiven und das differenzielle Kopplungselement kapazitiven Charakter. In den Zeichnungen liegt der Rückführpfad parallel zur Kollektor-Emitter-Strecke eines der beiden Transistoren und wird über eine induktive Komponente geschlossen, was bei einer Ausgestaltung der induktiven Komponente als Spule einen DC-Kurzschluss der Kollektor-Emitter-Strecke bedeuten würde.

In drei weiteren Ausgestaltungen werden kapazitive Rückkopplungspfade angegeben. Das differenzielle Kopplungselement liegt zwischen Knoten, an die Emitter der Transistoren, die Rückführpfade und jeweils ein Bias-Element angeschlossen ist, das einen der Knoten mit einem Massepotenzial "Ground" verbindet. Dieses Massepotenzial stellt offensichtlich eine Gleichstrommasse dar, denn die WO99/43079 unterscheidet dieses Massepotenzial ausdrücklich von einem "virtuellen ground point", also von der AC-Masse. Als Bias-Elemente werden Stromquellen oder Stromsenken offenbart. Die an den Transistoren liegenden Anschlüsse der Stromquellen/Stromsenken sind nur durch das differenzielle Kopplungselement voneinander getrennt. Es ist daher jeweils ein separates Bias-Element in Form einer Stromquelle oder Stromsenke erforderlich, um einen AC-Kurzschluss des differenziellen Kopplungselements zu verhindern.

Wegen des Rückführpfades werden solche Oszillatoren auch als Feedback-Oszillatoren bezeichnet. Ferner sind auch sogenannte Reflexionsoszillatoren bekannt, zum Beispiel aus der Veröffentlichung "Optimizing MMIC Reflection-Type Oscillators", 2004 IEEE MTT-S Digest, Seite 1341 ff. Nach dieser Schrift besteht ein solcher Oszillator aus einem aktiven Bauelement, das über drei Impedanzen an eine AC-Masse angeschlossen ist. Dabei sind zwei Anschlüsse so an Masse angeschlossen, dass sich am dritten Anschluss eine negative Impedanz einstellt. Dort wird eine dritte Impedanz an die AC-Masse angeschlossen, um die Resonanzfrequenz einzustellen.

Wie bereits in der WO99/43079 ausgeführt wird, müssen beim Entwurf eines Oszillators immer Kompromisse zwischen Forderungen eingegangen werden, von denen eine häufig nur zu Lasten einer anderen erfüllt werden kann. Eine nicht abschließende Aufzählung solcher Forderungen umfasst zum Beispiel eine Realisierbarkeit in hohen Stückzahlen zu möglichst geringen Kosten, einen geringem Platzbedarf der Oszillatorschaltung, einen geringen Stromverbrauch, ein großes Signal zu Rausch - Verhältnis, und eine geringe Empfindlichkeit gegenüber herstellungsbedingten Streuungen der Schaltungseigenschaften.

Vor diesem Hintergrund besteht die Aufgabe der Erfindung in der Angabe einer Integrierten differenziellen Oszillatorschaltung mit einem verbesserten Signal zu Rausch-Verhältnis, einem breiteren Abstimmbereich und/oder einer höheren Güte, einem höheren Wirkungsgrad (Effizienz) und einem geringeren Einfluss herstellungsbedingter Streuungen der Schaltungseigenschaften.

Diese Aufgabe wird bei einer Oszillatorschaltung der eingangs genannten Art dadurch gelöst, dass der Ausgang über eine erste Induktivität und eine zweite Induktivität des Rückkopplungsnetzwerks transformatorisch mit dem Eingang gekoppelt ist, wobei der Ausgang über die erste Induktivität und einen ersten Gleichstrompfad an ein erstes DC-Potenzial, und der Eingang über die zweite Induktivität und einen zweiten Gleichstrompfad an ein zweites DC-Potenzial der Gleichstromversorgung angeschlossen ist.

Durch diese Merkmale wird die Aufgabe der Erfindung vollständig gelöst.

Durch den Anschluss der zweiten Induktivität an das zweite DC-Bezugspotenzial wird der für eine Entdämpfung des Schwingkreises und eine Arbeitspunkteinstellung der Verstärkerschaltung notwendige Gleichstrompfad über die zweite Induktivität zu der Verstärkerschaltung geführt. Induktivitäten werden in der Regel metallisch ausgeführt und weisen im Vergleich zu Bias-Elementen aus Halbleitermaterial einen verschwindend geringen Ohm'schen Widerstand auf.

Bei solch geringen Ohm'schen Widerstandswerten spielen kleine Unterschiede in den Widerstandswerten, wie sie durch Prozessvariationen bei der Herstellung Integrierter Oszillatorschaltungen auftreten können, nur noch eine untergeordnete Rolle. Bei der üblichen Erzeugung der DC-Anbindung der Verstärkerschaltung mit Hilfe von Widerständen aus Halbleitermaterial oder mit Hilfe von aktiven Stromquellen oder Stromsenken, die Transistoren enthalten, treten dagegen durch Prozessvariationen vergleichsweise große Streuungen der Widerstandswerte auf.

Außerdem sind die in den Zuleitungen auftretenden Rauschspannungen u_r direkt proportional zum Wert R ihrer Widerstände (u_r² = 4k_{B}TR, k_{B} = Boltzmannkonstante, T = absolute Temperatur).

Wegen der kleinen Widerstandswerte der Induktivitäten wird durch die Erfindung eine rauscharme DC-Anbindung der Verstärkerschaltung mit verringerter Schwankungsbreite der Auswirkung von Prozessvariationen bereitgestellt. Dieser Vorteil ist gerade wegen der differenziellen Signalverarbeitung von großer Bedeutung: Eine differenzielle Signalverarbeitung erfordert eine möglichst weitgehende Symmetrie in der Gleichstromversorgung der Verstärkerschaltung. Abweichungen in der Symmetrie können zu Unterschieden im DC-Potenzial von Anschlüssen des differenziellen Eingangs der Verstärkerschaltung führen. Solche Potenzialunterschiede können beim eingangs genannten Stand der Technik durch fertigungsbedingte Streuungen der Eigenschaften der beiden Stromquellen auftreten und führen dort zu unterschiedlichen Arbeitspunkten von als Verstärkern dienenden Transistoren. Diese werden dann nicht mehr exakt differenziell ausgesteuert, was negative Auswirkungen auf die Qualität des Signal-Rausch-Verhältnisses des Ausgangssignals der Oszillatorschaltung hat.

Durch den erfindungsgemäßen Anschluss des Eingangs der Verstärkerschaltung über die zweite Induktivität und den zweiten Gleichstrompfad an das zweite DC-Potenzial der Gleichstromversorgung wird dagegen insgesamt ein sehr niedriger Widerstand der Gleichstromversorgung erzielt. Wegen der differenziellen Ausgestaltung sind zwar nach wie vor getrennte Gleichstrompfadabschnitte zu den Anschlüssen des differenziellen Eingangs erforderlich. Diese Abschnitte werden aber durch die extrem niederohmigen Induktivitäten realisiert. Der Gesamtwiderstand der Gleichstromversorgung wird daher auf der Eingangsseite der Verstärkeranordnung durch Bauteile wie Widerstände oder Transistoren einer Stromquelle der Gleichstromversorgung dominiert, die in einem für beide Anschlüsse des differenziellen Eingangs gemeinsamen Schaltungsabschnitt angeordnet sind. Durch diese Einflüsse werden Unsymmetrien in der Gleichstromversorgung der Verstärkerschaltung fast vollständig vermieden.

Die transformatorische Kopplung erlaubt eine Rückführung von AC-Signalen, während sie Gleichströme blockiert. Für Ausgestaltungen der Verstärkerschaltung mit Transistoren erlaubt sie damit insbesondere für die Transistorfunktion notwendige Kollektor- und Emitter-DC-Potenziale oder Drain- und Source_DC-Potenziale.

Da der Abstimmbereich, also die Bandbreite, über der die Resonanzfrequenz abstimmbar ist, mit zunehmender Frequenz durch parasitäre Kapazitäten des Schwingkreises und/oder der Verstärkerschaltung begrenzt wird, ergibt sich als ein weiterer großer Vorteil der transformatorischen Kopplung eine Verringerung der parasitären Kapazitäten und damit eine Vergrößerung der Breite des Frequenzabstimmbereichs. Die mit der transformatorischen Kopplung erreichte Verringerung parasitärer Kapazitäten kann entweder zu einer maximalen Vergrößerung des Abstimmbereichs bei gleichbleibender Güte oder zu einer maximalen Erhöhung der Güte bei gleichbleibendem Abstimmbereich oder zu einer gleichzeitigen Verbesserung von Güte und Abstimmbereich auf submaximale Werte verwendet werden.

Weitere Vorteile ergeben sich aus der Beschreibung und den beigefügten Figuren.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Zeichnungen

Ausführungsbeispiele der Erfindung sind in den Zeichnungen dargestellt und werden in der nachfolgenden Beschreibung näher erläutert. Es zeigen, jeweils in schematischer Form:
- Fig. 1: ein bekanntes Blockschaltbild einer Oszillatorschaltung;
- Fig. 2: ein erstes Ausführungsbeispiel der Erfindung;
- Fig.3 3: eine erste Ausgestaltung einer Verstärkerschaltung mit Transistoren in Basisschaltung;
- Fig.4: eine Ausgestaltung einer Verstärkerschaltung mit Transistoren in Emitterschaltung;
- Fig. 5: Ausgestaltungen von einstellbaren Kapazitäten;
- Fig. 6: Abhängigkeiten der Schwingkreisgüte von einem Abstimmbereich und einer Größe parasitärer Kapazitäten;
- Fig. 7: eine mögliche geometrische Ausgestaltung der Schwingkreisinduktivitäten und der Anordnung von Kapazitäten;
- Fig. 8: eine weitere Ausgestaltung mit zusätzlichen Kapazitäten für eine optimierte Impedanzanpassung;
- Fig. 9: eine Ausgestaltung mit über die Länge der Induktivitäten verteilten zusätzlichen Kapazitäten;
- Fig. 10: eine Ausgestaltung mit überlappenden Leiterschleifen in verschiedenen Ebenen; und
- Fig. 11: einen Querschnitt durch den Gegenstand der Fig. 10.

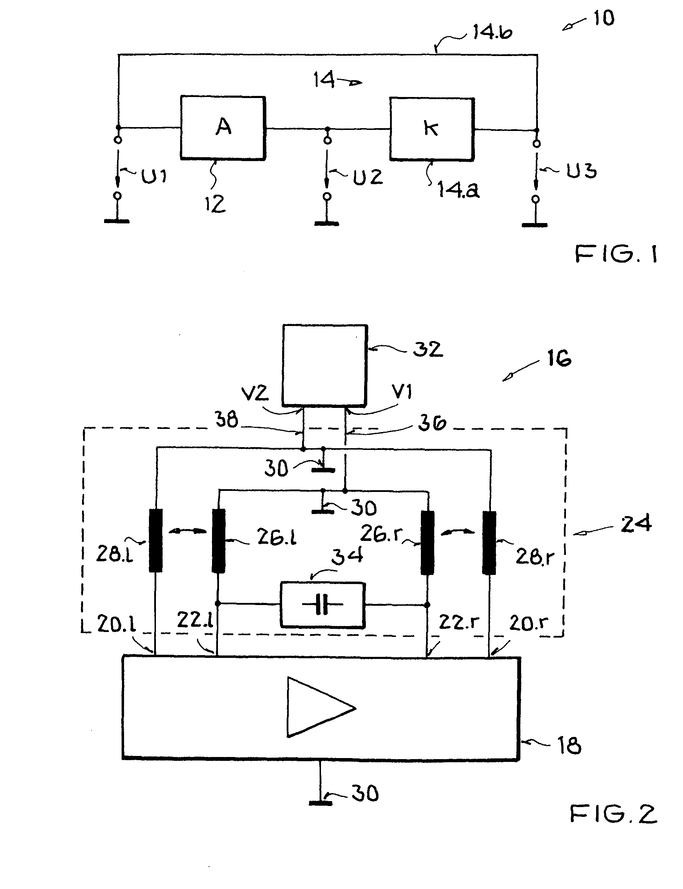

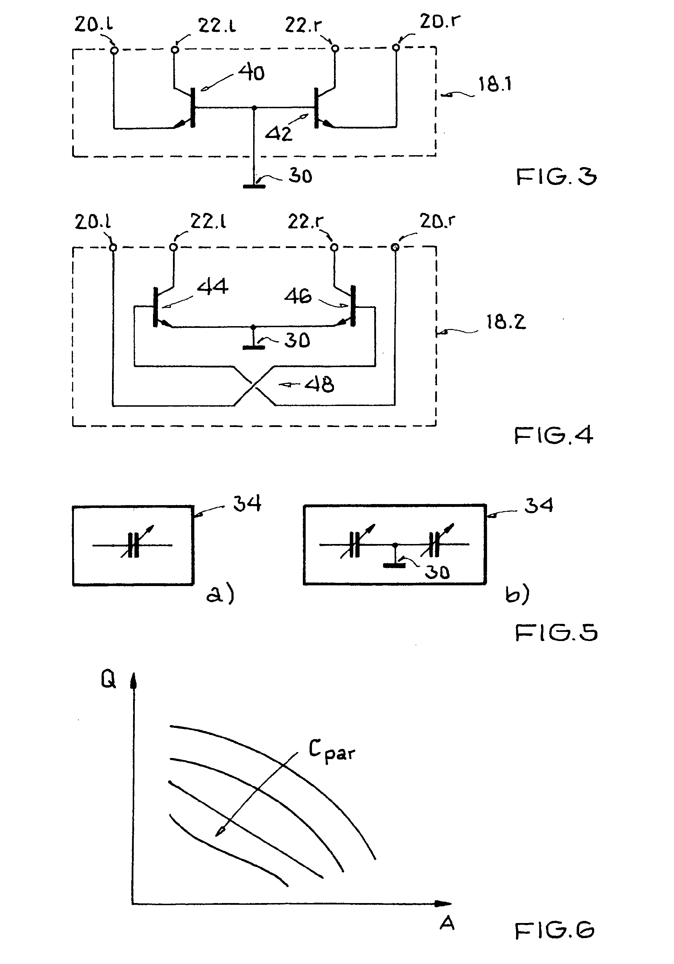

Dabei bezeichnen gleiche Bezugszeichen in allen Figuren jeweils gleiche Elemente. Im Einzelnen zeigt Fig. 1 das bekannte Prinzip einer Feedback-Oszillatorschaltung 10, die generell aus einer Verstärkerschaltung 12 mit einem frequenzselektiven Rückkopplungsnetzwerk 14 besteht. Die Verstärkerschaltung verstärkt ein Eingangssignal U1 zu einem Ausgangssignal U2 = A*U1. Das Rückkopplungsnetzwerk 14 selektiert eine Resonanzfrequenz aus dem Ausgangssignal U2 und führt das Ausgangssignal der selektierten Frequenz in abgeschwächter Form als Signal U3 = k*U2 an den Eingang zurück. Eine stabile Schwingung des Ausgangssignals U2 stellt sich bekanntlich dann ein, wenn die Amplitude des rückgeführten Signals U3 gleich der Amplitude des Eingangssignals U1 ist. Bezeichnet man das Produkt aus Verstärkung A und Dämpfung k als Schleifenverstärkung g, muss g also gleich 1 sein. Ferner muss die Phasenverschiebung zwischen U1 und U3 eine konstruktive Interferenz erlauben, im Idealfall also ein ganzzahliges Vielfaches von 2π betragen. Diese Zusammenhänge gelten ganz allgemein und sind bekannt (Vergleiche Tietze Schenk, Halbleiterschaltungstechnik, 9. Auflage Seiten 458, 459). Man kann das Rückkopplungsnetzwerk noch weiter unterteilen in einen ersten Teil 14.a, der die Frequenz selektiert, und einen zweiten Teil 14.b, der das selektierte Signal zum Eingang zurückführt.

Fig. 2 zeigt ein erstes Ausführungsbeispiel der Erfindung mit einer Integrierten Oszillatorschaltung 16, die mit differenziellen Signalen arbeitet. Die Integrierte differenzielle Oszillatorschaltung 16 weist eine Verstärkerschaltung 18 mit einem differenziellen Eingang 20.1, 20.r und einem differenziellen Ausgang 22.1, 22.r sowie ein frequenzselektives Rückkopplungsnetzwerk 24 mit einer ersten Induktivität 26.1, 26.r und einer zweiten Induktivität 28.1, 28.r und eine Gleichstromversorgung 32 auf. Das frequenzselektive Rückkopplungsnetzwerk 24 weist neben den Induktivitäten 26.1, 26.r und 28.1, 28.r wenigstens eine Kapazität 34 auf. Die Kapazität 34 bildet mit der ersten Induktivität 26.1, 26.r einen Parallelschwingkreis, der zwischen dem differenziellen Ausgang 22.1 und 22.r der Verstärkerschaltung 18 und der Gleichstromversorgung 32 liegt. Die Frequenzselektivität ergibt sich daraus, dass der Parallelschwingkreis außerhalb seiner Resonanzfrequenz eine niedrige Impedanz besitzt, die Signale mit entsprechenden Frequenzen über die Gleichstromversorgung ableitet. Nur innerhalb der Resonanzbandbreite ist die Impedanz groß genug, um ein Signal in die eigentliche Rückführung einzuspeisen.

Die Oszillatorschaltung 16 aus der Fig. 2 wird, wie auch die im Übrigen vorgestellten Oszillatorschaltungen, in einem üblichen Halbleiterherstellungsprozess als Integrierte Schaltung auf einem Halbleitersubstrat realisiert. Dabei werden die Induktivitäten bevorzugt durch strukturierte Leiterbahnabschnitte in Metallisierungsebenen gebildet. Die Kapazitäten werden beispielsweise mit einer dünnen Oxidschicht als Dielektrikum gebildet, die auf einer hochdotierten Schicht aus Halbleitermaterial liegt und durch eine Metallschicht bedeckt wird (MIS = metal insulator semiconductor - Struktur). Auch MIM-Strukturen (metal insulator metal) kommen in Frage.

Der differenzielle Ausgang 22.1. 22.r ist über die erste Induktivität 26.1, 26.r und die zweite Induktivität 28.1, 28.r des Rückkopplungsnetzwerks 24 transformatorisch (magnetisch) mit dem Eingang 20.1, 20.r gekoppelt. Dabei ist der Ausgang 22.1. 22.r über die erste Induktivität 26.1, 26.r und einen ersten Gleichstrompfad 36 an ein erstes DC-Potenzial V1 der Gleichstromversorgung 32 angeschlossen. Der Eingang 20.1, 20.r ist über die zweite Induktivität 28.1. 28.r und einen zweiten Gleichstrompfad 38 an ein zweites DC-Potenzial V2 der Gleichstromversorgung 32 angeschlossen.

Fig. 2 zeigt damit eine Oszillatorschaltung 16 mit einer rein transformatorischen Rückkopplung. Dabei ist die erste Induktivität 26.1, 26.r und die zweite Induktivität 28.1, 28.r jeweils in eine linke Teilinduktivität 26.1, 28.1 und eine rechte Teilinduktivität 26.r, 28.r aufgeteilt. Die linken Teilinduktivitäten 26.1, 28.1 und die rechten Teilinduktivitäten 26.r, 28.r sind jeweils paarweise benachbart zueinander angeordnet, um eine transformatorische Kopplung zu erzielen. Diese Kopplung ist in der Fig. 2 durch Pfeile veranschaulicht. Die Kopplung erfolgt dadurch, dass das Magnetfeld der einen Induktivität die andere Induktivität durchdringt und umgekehrt. Die transformatorische Kopplung besitzt den Vorteil eines vereinfachten Schaltungsaufbaus (weniger Bauelemente) und einer galvanischen Trennung. Weitere Vorteile ergeben sich in Verbindung mit einer abstimmbaren Schwingkreis-Kapazität 34 und werden weiter unten erläutert.

Der Gleichstrompfad 36 für den Anschluss an das erste Gleichpotenzial V1 ist bevorzugt an einen Mittelabgriff der ersten Induktivität 26.1, 26.r angeschlossen. Analog dazu ist der Gleichstrompfad 38 für den Anschluss an das zweite Gleichpotenzial V2 bevorzugt an einen Mittelabgriff der zweiten Induktivität 28.1, 28.r angeschlossen. Jeder Mittelabgriff bildet dann aufgrund der Symmetrie der Anordnung eine Wechselstrommasse 30 (AC Ground), an der kein Wechselstromanteil auftritt.

Damit können alle für den Betrieb der Oszillatorschaltung 16 notwendigen Potenziale von außen über vorhandene Bauteile wie die Induktivitäten 26.1, 26.r, 28.1, 28.r zugeführt werden, die selbst an gewissermaßen ruhende AC-Potenziale, also an Wechselstrommasse n 30 mit verschiedenen DC-Potenzialen angeschlossen sind.

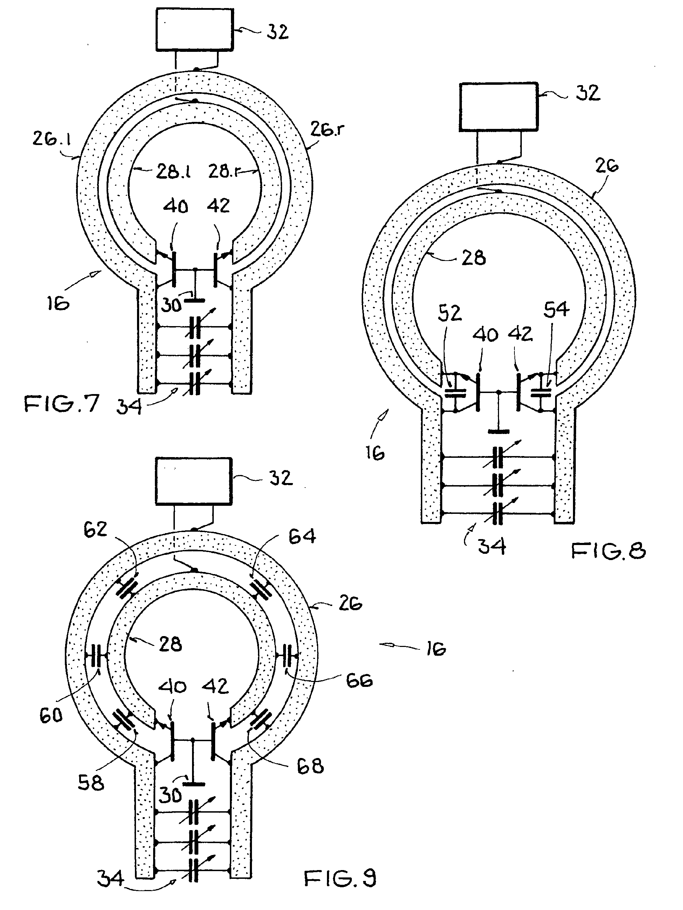

Fig. 3 zeigt eine erste Ausgestaltung 18.1 einer Verstärkerschaltung 18, wie sie in der Fig. 2 verwendbar ist. In der Ausgestaltung 18.1 weist die Verstärkerschaltung 18 zwei Bipolartransistoren 40, 42 in Basisschaltung auf, deren Basen miteinander verbunden sind, wobei die Verbindung der beiden Basen in dieser Schaltung eine Wechselstrommasse 30 bildet. Der Kollektor des Transistors 40 bildet den Ausgang 22.1 der Verstärkerschaltung 18. und der Kollektor des Transistors 42 bildet ihren Ausgang 22.r. Entsprechend bildet der Emitter des ersten Transistors 40 den Eingang 20.l der Verstärkerschaltung und der Emitter des zweiten Transistors 42 bildet ihren Eingang 20.r.

Bei einem Einsatz der Ausgestaltung 18.1 als Verstärkerschaltung 18 in der Fig. 2 ist je ein Eingang 20.l (20.r) mit einem Ausgang 22.1 (22.r) über das Rückkopplungsnetzwerk 24 verbunden, wobei die Verbindung über eine transformatorische Kopplung der linken Induktivitäten 28.1, 26.1 (rechten Induktivitäten 28.r, 26.r) erfolgt. Die transformatorische Kopplung erlaubt eine Rückführung von AC-Signalen, während sie Gleichströme blockiert.
Sie erlaubt damit insbesondere für die Transistorfunktion notwendige Kollektor/Emitter-DC-Potenziale.

Ein Signal am Kollektor eines der beiden Transistoren 40, 42 wird über die zugehörige transformatorische Kopplung auf den Emitter desselben Transistors 40, 42 zurückgekoppelt, wodurch der Transistor 40, 42 an seinem Emitter ausgesteuert wird. Bei einer solchen Aussteuerung folgt das Signal am Kollektor als Ausgang der Verstärkerschaltung 18 dem Eingangssignal am Emitter mit gleicher Phase. Die Phasenbedingung für eine Oszillation ist insofern erfüllt.

Alternativ zu der Ausgestaltung 18.1 nach der Fig. 3 kann die Verstärkerschaltung 18 auch zwei Bipolartransistoren 44, 46 in Emitterschaltung aufweisen, wie es in der Fig. 4 als Ausgestaltung 18.2 dargestellt ist. In diesem Fall sind die Emitter der beiden Transistoren 44, 46 miteinander verbunden und bilden an einem Punkt der Verbindung eine Wechselstrommasse 30, an der sich AC-Anteile beider Emitterpotentiale kompensieren (AC Ground).

In dieser Ausgestaltung ist der Eingang 20.1 (20.r) der Verstärkerschaltung 18.2 mit der Basis des Transistors 46 (44) verbunden, während der Ausgang 22.1 (22.r) mit dem Kollektor des Transistors 44 (46) verbunden ist. Bei einem Einsatz der Ausgestaltung 18.2 als Verstärkerschaltung 18 in der Fig. 2 ist je ein Eingang 20.1 (20.r) mit einem Ausgang 22.1 (22.r) über eine Rückführung mit transformatorischer Kopplung über die linken Induktivitäten 28.1, 26.1 (rechten Induktivitäten 26.r, 28.r) verbunden. Die transformatorische Kopplung erlaubt auch hier eine Rückführung von AC-Signalen, während sie Gleichströme blockiert und damit insbesondere für die Transistorfunktion notwendige Kollektor- und Emitter-DC-Potenziale zulässt.

Bei einer Aussteuerung eines Transistors mit einem Eingangssignal an seiner Basis folgt das Ausgangssignal am Kollektor desselben Transistors dem Eingangssignal immer mit einer Phasenverschiebung von π. Da der Parallelschwingkreis aus der ersten Induktivität 26.1. 26.r und der Kapazität 34 zwischen den Kollektoren der beiden Transistoren 44 und 46 liegt und da sich über dem Parallelschwingkreis im Betrieb der Oszillatorschaltung 16 eine Wechselspannung einstellt, erzeugt der Parallelschwingkreis zwischen den beiden angeschlossenen Kollektoren eine zusätzliche Phasenverschiebung von π. Am Kollektor des Transistors 44 tritt also eine Phasenverschiebung von π gegenüber dem Kollektor des Transistors 46 auf. Je nach Vorzeichen der Phasenverschiebung ist die gesamte Phasenverschiebung zwischen der Basis des Transistors 46 und dem Kollektor des Transistors 44 damit entweder gleich 0 oder gleich 2π. Durch die Kreuzkopplung 48, bei der die Basis des linken (rechten) Transistors 44 (46) an den rechten Eingang 20.r (linken Eingang 20.1) angeschlossen ist trifft das vom Kollektor des Transistors 44 zur Basis des Transistors 46 propagierende Signal dort insgesamt mit einer Phasenverschiebung von Null oder 2π zum Eingangssignal ein. Dies gilt auch umgekehrt, so dass die Phasen-Voraussetzung für eine Oszillation insoweit auch bei der Emitterschaltung der Ausgestaltung 18.2 erfüllt ist.

In jedem Fall zeigen die Figuren 3 und 4 Ausgestaltungen mit einer transformatorischen Kopplung zwischen einem Eingang 20.1, 20.r und einem Ausgang 22.1, 22.r von Ausgestaltungen 18.1, 18.2 einer differenziellen Verstärkerschaltung 18. Aus der Emitterschaltung ergibt sich durch Vertauschen von Emitter und Kollektor der beiden Transistoren 44, 46 und gleichzeitiger Anpassung der Polarität der Gleichspannungsversorgung 32 in einer weiteren Ausgestaltung eine Verstärkerschaltung mit zwei Bipolartransistoren in Kollektorschaltung.

Auch wenn die bisher beschriebenen Ausgestaltungen 18.1, 18.2 von Verstärkerschaltungen 18 unter Verwendung von bipolaren npn-Transistoren 40, 42, 44, 46 erläutert wurden, versteht es sich, dass korrespondierende Ausgestaltungen auch mit bipolaren pnp-Transistoren oder mit unipolaren Transistoren vom n-Kanal-Typ oder vom p-Kanal-Typ aufgebaut werden können. In den Ausgestaltungen mit unipolaren Transistoren werden solche Transistoren analog zur (bipolaren) Basisschaltung, Emitterschaltung und Kollektorschaltung in (unipolarer) Gateschaltung, Sourceschaltung oder Drainschaltung verwendet.

In einer weiteren bevorzugten Ausgestaltung sind die Werte der Kapazität 34 der Fig. 2 kontinuierlich und/oder schrittweise einstellbar. Beispiele bekannter kontinuierlich einstellbarer kapazitiver Bauelemente sind Varaktor-, Kapazitäts-, Schottky-, MOS- und MEM-Dioden. Beispiele kapazitiver Bauelemente mit diskret änderbarem Kapazitätswert sind sogenannte CDAC-Schaltungen (CDAC = Capacitor digital-to-analog converter, vergleiche zum Beispiel US 2005/0083221), geschaltete MIM-Kondensatoren (MIM = Metal-Insulator-Metal) und geschaltete PolyCaps. Wesentlich ist in jedem Fall, dass sich die Kapazitäten in Integrierte Schaltungen integrieren lassen, was für die genannten Ausgestaltungen zutrifft.

Die einstellbare Kapazität 34 ist schematisch in der Fig. 5 dargestellt. Fig. 5a zeigt eine Ausgestaltung der ersten Kapazität 34 mit einem einzelnen einstellbaren kapazitiven Bauteil.
Fig. 5b zeigt eine Ausgestaltung der Kapazität 34 mit zwei einstellbaren kapazitiven Bauteilen, zwischen denen sich eine Wechselstrommasse 30 bildet.

Mit der einstellbaren Kapazität 34 bildet die Oszillatorschaltung 16 zum Beispiel einen voltage controlled oscillator VCO 16. Bei einem VCO 16 werden aus technologischen Gründen fast ausschließlich kapazitive Bauelemente 34 als ansteuerbare Stellglieder zur Frequenzabstimmung benutzt. Dabei wird der Abstimmbereich, also die Bandbreite, über der die Resonanzfrequenz abstimmbar ist, mit zunehmender Frequenz durch parasitäre Kapazitäten des Schwingkreises und/oder der Verstärkerschaltung 18 begrenzt. Hier ergibt sich ein weiterer großer Vorteil der transformatorischen Kopplung gegenüber sonst verwendeten kapazitiven Kopplungen. Die kapazitiven Kopplungen zählen im Hinblick auf die Breite des Frequenzabstimmbereichs zu den störenden parasitären Kapazitäten.

Der Abstimmbereich ist proportional zur Wurzel des Quotienten aus der Differenz der maximalen und minimalen Schwingkreiskapazität im Zähler und der Summe der maximalen und der minimalen Schwingkreiskapazität im Nenner. Dabei setzt sich der Wert der Schwingkreiskapazität jeweils aus dem abstimmbaren Anteil und den parasitären Anteilen oder Kapazitäten zusammen. Im Gegensatz zu einer kapazitiven Kopplung ergeben sich bei der transformatorischen Kopplung weniger große Werte der parasitären Kapazitäten, da die Kopplungskapazitäten wegfallen können. Die Werte der Kopplungskapazitäten sind in der Regel größer als der Wert des abstimmbaren Anteils 34 der Schwingkreiskapazität. Da die parasitären Kapazitäten bei der Differenzbildung im Zähler immer wegfallen, nimmt die Breite des Abstimmbereichs bei sinkenden parasitären Kapazitätswerten zu. Da der parasitäre Kapazitätswert bei der transformatorischen Kopplung klein ist, ist der Nenner bei der transformatorischen Kopplung entsprechend klein und es ergibt sich ein entsprechend großer Abstimmbereich.

Außerdem hängt die Güte Q des Schwingkreises vom Quotienten aus der maximalen Kapazität im Zähler und der minimalen Kapazität im Nenner ab. Der Wert der Güte sinkt im allgemeinen zunächst flach und dann steiler mit zunehmendem Quotienten ab. Die steil abfallende Güte begrenzt damit den maximalen Abstimmbereich.

Der Quotient selbst nähert sich mit abnehmender Größe der parasitären Kapazitäten von einem Grenzwert 1 monoton steigend einem Wert des Quotienten an, der nur vom minimalen und maximalen Wert des abstimmbaren Kapazitätsanteils bestimmt wird. Je kleiner die parasitären Kapazitäten sind, desto größer ist der Quotient.

Stellt man die Güte Q als Funktion des Abstimmbereichs A dar, ergibt sich qualitativ die in der Fig. 6 dargestellte Kurvenschar mit der Größe Cpar der parasitären Kapazitäten als Parameter. Die unteren Kurven gehören zu größeren Werten von Cpar. Die mit der transformatorischen Kopplung erreichte Verringerung von Cpar kann daher entweder zu einer maximalen Vergrößerung des Abstimmbereichs bei gleichbleibender Güte oder zu einer maximalen Erhöhung der Güte bei gleichbleibendem Abstimmbereich oder zu einer gleichzeitigen Verbesserung von Güte und Abstimmbereich auf submaximale Werte verwendet werden.

Fig. 7 zeigt ein mögliches layout einer Integrierten Oszillatorschaltung 16 mit weitgehend kreisförmigen, konzentrischen Schwingkreisinduktivitäten 28, 26. In jedem Fall besteht jede Schwingkreisinduktivität 28, 26 aus mindestens einer Windung oder Transmissionsleitung. Durch einen Mittelabgriff, an den jeweils die Gleichstromversorgung 32 angeschlossen ist, werden die Induktivitäten 28, 26 in linke Induktivitäten 28.1, 26.1 und rechte Induktivitäten 28.r, 26. r aufgeteilt. Fig. 7 repräsentiert unter anderem eine Ausgestaltung der Oszillatorschaltung 16, bei der die erste Induktivität 26 und die zweite Induktivität 28 wenigstens jeweils eine Leiterschleife aufweist, wobei beide Leiterschleifen in einer Ebene der Integrierten Schaltung 16 liegen und eine der Leiterschleifen in einem von der anderen Leiterschleife umrandeten Bereich der Ebene verläuft.

Die Leiterschleifen können nahezu kreisförmig, elliptisch oder rechteckig sein. An Stelle einer reinen Rechteckform, Kreisform oder elliptischen Form können andere Ausgestaltungen auch Leiterschleifen mit stückweise geraden Abschnitten in regelmäßiger oder unregelmäßiger sowie konvexer oder konkaver Vieleckform und oder Leiterschleifen mit stückweise gekrümmten konkaven oder konvexen Abschnitten oder aus gekrümmten und geraden Abschnitten zusammengesetzte Mischformen aufweisen.

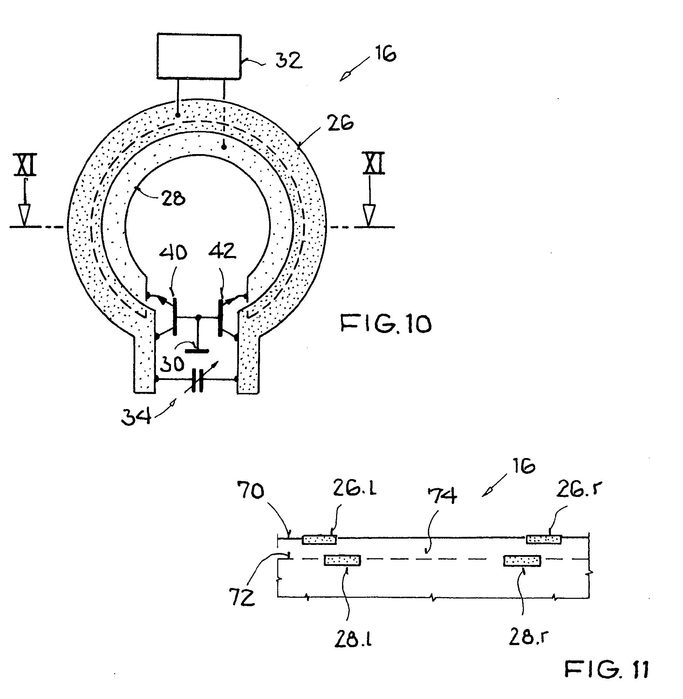

In einer weiteren Ausgestaltung weist das frequenzselektive Netzwerk 24 aus den Schwingkreisinduktivitäten und Kapazitäten eine zusätzliche kapazitive Kopplung zwischen der ersten Induktivität 26 und der zweiten Induktivität 28 auf, wie sie schematisch in den Fig. 8 bis 11 dargestellt ist. Die zusätzliche kapazitive Kopplung ermöglicht eine Optimierung der Eingangs- und/oder Ausgangsimpedanz der als Verstärker arbeitenden Transistoren. Bei der Ausgestaltung der Fig. 8 liegen zusätzliche Kapazitäten 52, 54 zwischen Kollektor und Emitter der in Basisschaltung angeordneten Transistoren 40, 42. Dies erlaubt eine optimierte Impedanzanpassung von Verstärkerschaltung und Rückkopplungsnetzwerk. Die optimierte Impedanzanpassung ergibt dann eine maximale Leistungsverstärkung (Wirkungsgrad) und Rauschanpassung und damit auch ein maximales Signal/Rausch-Verhältnis.

Bei der weiteren Ausgestaltung der Fig. 9 ist eine größere Zahl von zusätzlichen Kapazitäten 58, 60, ..., 68 über die Länge der Induktivitäten 26, 28 verteilt worden. Fig. 10 und der Querschnitt der Fig. 11 zeigen eine Ausgestaltung, bei der eine über die Länge der Induktivitäten 26, 28 verteilte zusätzliche Kapazität durch eine Überlappung der Induktivitäten 26, 28 in verschiedenen Ebenen 70, 72 eines Halbleitersubstrates 74 einer Integrierten Oszillatorschaltung 16 gebildet wird, so dass die erste Induktivität 26 und die zweite Induktivität 28 ganz oder teilweise überlappend zueinander angeordnet sind.

Bis auf die abstrahierte Ausgestaltung der Fig. 1 weisen alle bisher beschriebenen Oszillatorschaltungen eine transformatorische Rückführung auf. Sie können daher dem Typ der Feedback-Oszillatoren zugeordnet werden. Die Erfindung ist aber nicht auf eine Verwendung bei Feedback-Oszillatoren beschränkt, sondern kann auch bei Reflexionsoszillatoren verwendet werden. Ein Reflexionsoszillator entsteht zum Beispiel durch eine Abwandlung der Verstärkerschaltung 18.1 aus der Fig. 3, bei der die Basen der beiden Transistoren 40, 42 direkt, sondern über eine Impedanz beispielsweise aus zwei in Reihe liegenden LC-Netzwerken miteinander verbunden sind und wobei der Verbindungspunkt zwischen den LC-Netzwerken eine Wechselstrommasse bildet. Damit wird das Schaltungsprinzip eines Reflexionsoszillators in differenzieller Form verwirklicht: Jeder der jeweils drei Anschlüsse der beiden Transistoren 42, 50 ist über eine Impedanz mit einer Wechselstrommasse verbunden, wobei sich am Emitter jeweils ein negativer Widerstand ergibt, über den die beteiligten Schwingkreise entdämpft werden.

## Patentansprüche

1. Integrierte differenzielle Oszillatorschaltung (16), die eine Verstärkerschaltung (18) mit einem Eingang (20.1, 20.r) und einem Ausgang (22.1, 22.r), ein frequenzselektives Rückkopplungsnetzwerk (24) mit einer ersten Induktivität (26.1, 26.r) und einer zweiten Induktivität (28.1, 28.r) und eine Gleichstromversorgung (32) aufweist, **dadurch gekennzeichnet, dass** der Ausgang (22.1, 22.r) über die erste Induktivität (26.1, 26.r) und die zweite Induktivität (28.1, 28.r) des Rückkopplungsnetzwerks (24) transformatorisch mit dem Eingang (20.1, 20.r) gekoppelt ist, wobei der Ausgang (22.1, 22.r) über die erste Induktivität (26.1. 26.r) und einen ersten Gleichstrompfad (36) an ein erstes DC-Potenzial (V1), und der Eingang (20.1, 20.r) über die zweite Induktivität (28.1, 28.r) und einen zweiten Gleichstrompfad (38) an ein zweites DC-Potenzial (V2) der Gleichstromversorgung (32) angeschlossen ist.

2. Oszillatorschaltung (16) nach Anspruch 1, **dadurch gekennzeichnet, dass** der erste Gleichstrompfad (36) und der zweite Gleichstrompfad (38) jeweils eine Wechselstrommasse (30) bildet.

3. Oszillatorschaltung nach Anspruch 1, **dadurch gekennzeichnet, dass** der erste Gleichstrompfad (36) und der zweite Gleichstrompfad (38) jeweils über eine Kapazität an einen Bezugspotenzialanschluss angeschlossen sind.

4. Oszillatorschaltung (16) nach einem der vorhergehenden Ansprüche, **gekennzeichnet durch** eine Verstärkerschaltung (18.1; 18.2), die wenigstens einen Bipolartransistor (40, 42; 44, 46) in Basisschaltung, Emitterschaltung oder Kollektorschaltung aufweist.

5. Oszillatorschaltung (16) nach einem der Ansprüche 1 bis 3, **gekennzeichnet durch** eine Verstärkerschaltung (18), die wenigstens einen Unipolartransistor in Gateschaltung, Sourceschaltung oder Drainschaltung aufweist.

6. Oszillatorschaltung nach einem der vorhergehenden Ansprüche, **dadurch gekennzeichnet, dass** das frequenzselektive Netzwerk (24) eine abstimmbare Kapazität (34) aufweist, die mit der ersten Induktivität (26.1, 26.r) einen Parallelschwingkreis bildet.

7. Oszillatorschaltung (16) nach Anspruch 6, **gekennzeichnet durch** kontinuierlich oder schrittweise einstellbare Werte der abstimmbaren Kapazität (34).

8. Oszillatorschaltung (16) nach einem der vorhergehenden Ansprüche, **gekennzeichnet durch** eine zusätzliche kapazitive Kopplung zwischen der ersten Induktivität (26) und der zweiten Induktivität (28).

9. Oszillatorschaltung (16) nach Anspruch 8, **gekennzeichnet durch** separate Kapazitäten (52, 54; 58, 60, 62, 64, 66, 68), die elektrisch zwischen der ersten Induktivität (26) und der zweiten Induktivität (28) liegen.

10. Oszillatorschaltung (16) nach einem der vorhergehenden Ansprüche, **dadurch gekennzeichnet, dass** die erste Induktivität (26.1, 26.r) und die zweite Induktivität (28.1, 28.r) wenigstens jeweils eine Leiterschleife aufweisen.

11. Oszillatorschaltung (16) nach Anspruch 10, **dadurch gekennzeichnet, dass** beide Leiterschleifen in einer Ebene der Integrierten Oszillatorschaltung (16) liegen und ein der Leiterschleifen in einem von der anderen Leiterschleife umrandeten Bereich der Ebene verläuft.

12. Oszillatorschaltung (16) nach Anspruch 10, **dadurch gekennzeichnet dass** die beiden Leiterschleifen in verschiedenen Ebenen (70, 72) der Integrierten Oszillatorschaltung (16) liegen.

13. Oszillatorschaltung (16) nach Anspruch 12, **dadurch gekennzeichnet, dass** die beiden Leiterschleifen ganz oder teilweise überlappend zueinander angeordnet sind.
